(19)

Europäisches
Patentamt
European
Patent Office
Office européen
des brevets

(11) **EP 1 749 905 A1**

(12) **EUROPEAN PATENT APPLICATION**

(43) Date of publication:
**07.02.2007 Bulletin 2007/06**

(51) Int Cl.:
*C30B 29/10* (2006.01)   *C30B 13/00* (2006.01)

(21) Application number: **06015542.1**

(22) Date of filing: **26.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **26.07.2005 JP 2005216191**
**07.07.2006 JP 2006188296**

(71) Applicant: **KYOCERA CORPORATION**
**Kyoto-shi,**
**Kyoto 612-8501 (JP)**

(72) Inventors:
• **Hori, Kenji**
 **Soraku-gun, Kyoto 619-0237 (JP)**
• **Inoue, Shinji**
 **Soraku-gun, Kyoto 619-0237 (JP)**
• **Isogami, Mineo**
 **Soraku-gun, Kyoto 619-0237 (JP)**

(74) Representative: **Steil, Christian et al**
**Witte, Weller & Partner,**
**Postfach 10 54 62**
**70047 Stuttgart (DE)**

(54) **Method for manufacturing boride single crystal and substrate**

(57)    A method for manufacturing a boride single crystal (11) is provided, wherein an initial melt region (9) formed from an ingredient powder including a content of boron in excess of the stoichiometric composition of a boride is provided at one end in the longitudinal direction of a feed rod (6) formed from a ingredient powder containing boron and a metallic element that constitute the boride, the initial melt region (9) is heated to melt so as to form a molten zone (10), and the molten zone (10) is moved toward the other end of the feed rod (6) along the longitudinal direction, so as to grow the boride single crystal (11) in a portion of the feed rod (6) that the molten zone (10) has passed. A substrate formed by the manufacturing method and particularly suitable for epitaxial growing a semiconductor layer such as a GaN-based semiconductor layer thereon is also provided.

FIG. 2

**Description**

BACKGROUND OF THE INVENTION

Field of the Invention

The present invention relates to a method for manufacturing a boride single crystal, and to a substrate that is formed from the boride single crystal manufactured by the method particularly suitable for epitaxially growing a semiconductor layer such as a GaN semiconductor layer. Description of Related Arts

GaN-based semiconductors such as GaN and $Al_xGa_{1-x}N$ ($0 < x \leq 0.5$) are useful materials for forming light emitting devices such as a semiconductor light emitting diode and semiconductor laser that emit a blue light or an ultraviolet light, and therefore have been studied in extensive researches aimed at commercial applications. However, GaN-based semiconductors have high melting point and, when heated, tend to lose nitrogen that has a high equilibrium vapor pressure, thus making it difficult to manufacture a single crystal in bulk by a pulling-up method or the like.

For this reason, it has been studied to epitaxially grow a GaN-based semiconductor layer on the principal surface of the substrate using a semiconductor layer growing substrate made of sapphire or SiC by metal organic chemical vapor deposition (MOCVD) method or the like. However, conventional substrates have lattice constants significantly different from that of the GaN-based semiconductor layer that is epitaxially grown thereon (for example, a lattice mismatch between sapphire and GaN is 13.7%), which makes it impossible to form a satisfactory GaN-based semiconductor layer that has a low density of crystal dislocations (dislocation density).

Accordingly, such methods have been tried as an epitaxial growth of a GaN-based semiconductor layer on a low temperature deposited buffer layer on the principal surface of the substrate, and epitaxial growth of the GaN-based semiconductor layer by a growth method such as an epitaxial lateral overgrowth (ELO), a facet controlled ELO or the like; detailed description of which can be found in the following documents:

"Relationship between Dislocation Density and Emission Efficiency in AlGaN-based Light Emitting Diodes", Hiroshi Amano, et al., Journal of the Japanese Association for Crystal Growth Coorporation, Vol. 29, No. 3 (2002), pp.12-17
"Semiconductor based on Nitride of Group III Element" (Isamu Akasaki, 1st edition, published by BAIFUKAN CO., LTD. on December 8, 1999, pp122-124)
"Technology to Achieve Higher Luminance, Higher Efficiency and Longer Service Life of White LED Illumination System" (Hideto Miyake, 1st edition, 1st print, published by Technical Information Institute Co., Ltd. on March 27, 2003, pp.65-72

According to the methods described in these documents, dislocation density in the GaN-based semiconductor layer can be decreased to some extent. However, these methods have not yet been put into practice because of such problems as a high cost of manufacturing the semiconductor device such as a light emitting device that includes the GaN-based semiconductor layer and the manufacturing process cannot be repeated with high reproducibility.

Accordingly, it has recently been proposed in JP-2002-043223A and JP-2002-348200A, to epitaxially grow a GaN-based semiconductor layer on the principal surface of a substrate made of a $ZrB_2$ single crystal that has a little difference in the lattice constant in comparison to that of the conventional substrate made of sapphire or the like. Since the lattice mismatch between the $ZrB_2$ single crystal and the GaN-based semiconductor layer is as small as 0.56%, it is expected that an excellent GaN-based semiconductor layer having a significantly low dislocation density will be obtained by using the substrate made of the $ZrB_2$ single crystal.

The substrate made of the $ZrB_2$ single crystal can be made by a floating zone method (FZ method). For example, detailed description of the FZ method that employs high frequency induction heating (RF-FZ method) can be found in JP-2002-348200A mentioned above and in JP-H10-095699A.

In order to manufacture a semiconductor layer growing substrate from the $ZrB_2$ single crystal by the RF-FZ method, first, one kind or more of ingredient powders for forming the $ZrB_2$ single crystal are formed into a rod shape, which is sintered to make a feed rod. A seed crystal is attached to one end of the feed rod in the longitudinal direction thereof so as to provide the starting point of crystal growth. Then the end portion of the feed rod is heated by high frequency induction heating so that a portion of a predetermined length from the end in the longitudinal direction melts to form a molten zone.

Then as the molten zone is moved slowly toward the other end of the feed rod, the crystal grows with the seed crystal as a starting point in the portion that the molten zone has passed. Thus a rod shaped of the $ZrB_2$ single crystal is manufactured. When the rod made from $ZrB_2$ single crystal thus manufactured is cut along a predetermined crystal orientation thereafter, a semiconductor layer growing substrate made of the $ZrB_2$ single crystal is obtained.

## SUMMARY OF THE INVENTION

It has been known, however, that the ZrB$_2$ single crystal made by the conventional FZ method has a dislocation density not less than 10$^7$/cm$^2$ and a large full width at half maximum (FWHM) of X-ray reflectivity curve observed by an X-ray reflectivity method on the (0002) plane of crystal being 200 seconds or more, thus resulting in unsatisfactory crystallinity. The problem of unsatisfactory crystallinity in the single crystal that is manufactured occurs also in cases in which a boride single crystal constituted from boron and other metallic element other than the ZrB$_2$ single crystal is manufactured by the FZ method.

The main cause of the unsatisfactory crystallinity of the boride single crystal such as ZrB$_2$ single crystal made by the FZ method is that the melting point of a metallic element, such as zirconium that bonds with boron to form borides, is higher than that of boron, which requires to heat the molten zone to a high temperature so as to keep it in a molten state and prevent it from solidifying. Further, since the saturation vapor pressure of boron is higher than that of the metallic element, boron tends to be evaporated and lost from the molten zone that is heated to the high temperature.

When manufacturing a boride single crystal by the FZ method, it is a common practice to use a feed rod having a composition of boron and a metallic element in a proportion controlled so as to correspond to the stoichiometric composition of the boride in question. However, manufacturing a boride single crystal by the FZ method by using the feed rod requires to heat the molten zone to a high temperature so as to keep it in a molten state.

Consequently, boron tends to evaporate from the molten zone that is heated to a high temperature to prompt boron deficiency which causes defects such as boron defect and separation of metallic element in the boride single crystal that is made, thus resulting in a large number of macroscopic defects such as void defect, dislocation and crystal grain boundary that lowers crystallinity.

An object of the present invention is to provide a novel method for manufacturing a boride single crystal that has better crystallinity than that is obtained with the prior art, by the floating zone method and to provide a substrate that is made by the manufacturing method of the present invention and is suitable for epitaxial growth of semiconductor layer, particularly a GaN-based semiconductor layer thereon.

The present invention provides a method for manufacturing a boride single crystal by a floating zone method from a feed rod that is formed from an ingredient powder containing boron and a metallic element that constitute a boride, comprising the steps of: providing an initial melt region formed from an ingredient powder including a content of boron in excess of the stoichiometric composition of the boride, at one end of the feed rod in the longitudinal direction thereof and heating the initial melt region so as to melt and form a molten zone of a predetermined length in the longitudinal direction; and moving the molten zone from the initial melt region toward the other end of the feed rod along the longitudinal direction, so as to grow the boride single crystal in a portion of the feed rod that the molten zone has passed.

According to the manufacturing method of the present invention, since the melting point of boron is lower than that of the metallic element that forms the boride together with the boron, the molten zone formed by heating and melting the initial melt region that is made of the ingredient powder including a content of boron in excess of the stoichiometric composition of the boride can be maintained in a molten state at a temperature lower than in the case of a molten zone formed by melting a feed rod corresponding to the conventional stoichiometric composition.

As a consequence, the temperature of the molten zone can be set lower than in the case of the prior art, so that boron can be suppressed from evaporating from the molten zone. Essentially, along with the excessive content of boron in the initial melt region mentioned previously, this feature makes it possible to suppress boron deficiency that occurs in the boride single crystal grown in the portion that the molten zone has passed.

Thus the manufacturing method of the present invention makes it possible to manufacture the boride single crystal having an excellent crystallinity where macroscopic defects such as void defect, dislocation and crystal grain boundary are suppressed from occurring due to fewer defects such as boron defect and separation of metallic element caused by the boron deficiency.

According to the present invention, it is preferable that not only the initial melt region but also the entire feed rod is formed from the ingredient powder that includes a content of boron in excess of the stoichiometric composition of the boride. In the case the feed rod is formed from the ingredient powder, the temperature of the molten zone can be set lower than that of the prior art as described above so as to improve the effect of suppressing boron from evaporating from the molten zone, and also both the initial melt region and the feed rod essentially include an excessive content of boron, therefore, boron can be suppressed more reliably from falling into deficiency in the boride single crystal that is grown in a portion that the molten zone has passed. As a result, the boride single crystal having an excellent crystallinity can be manufactured.

The present invention can be preferably applied to the manufacture of a boride single crystal that contains a boride represented by the formula (1), particularly the boride single crystal containing ZrB$_2$ that can form a GaN-based semiconductor layer thereon:

$$MB_2 \qquad (1)$$

wherein M represents at least one metallic element selected from the group consisting of Zr, Ti, Cr, Hf and Ta.

According to the manufacturing method of the present invention, when manufacturing the boride single crystal that contains the boride represented by the formula (1), it is preferable to form the feed rod from an ingredient powder containing boron and a metallic element that constitute the boride represented by the formula (1) and having a content of boron [B1] to the total amount of the boron and the metallic element set to [B1] = 67 to 72 mol%.

In case the content [B1] of boron is lower than the range described above, namely that of stoichiometric composition, since the molten zone gradually shifts into the state of boron deficiency as the molten zone is moved toward the other end of the feed rod, the temperature that enables to maintain the molten zone in the molten state may gradually increase and eventually leads to solidification, thus making it impossible to continue the manufacture of the boride single crystal.

Also in the case the heating temperature is raised in line with the increase in the temperature that enables to maintain the molten zone in the molten state, the amount of boron that evaporates from the molten zone increases, therefore, there is a possibility that the boron falls into deficiency in the boride single crystal that is grown in the portion that the molten zone has passed, thus resulting in a lower crystallinity of the boride single crystal that is manufactured.

In the case the content [B1] of boron is higher than the range described above, boron becomes excessive and is likely to separate in the boride single crystal that is grown in the portion that the molten zone has passed. As a result, the crystallinity of the boride single crystal that is manufactured may become lower contrary to the intention. There is also such a possibility that the molten zone becomes too soft and droops during the process, thus making it impossible to continue the manufacture of the boride single crystal. In the case the content [B1] of boron is in the range described above, in contrast, the crystallinity of the boride single crystal that is manufactured can be improved further.

When manufacturing the boride single crystal that contains the boride represented by the formula (1) by the manufacturing method of the present invention, it is preferable to form the initial melt region from an ingredient powder containing boron and a metallic element that constitute the boride represented by the formula (1) and having a content of boron [B2] to the total amount of the boron and the metallic element set to [B2] = 72 to 90 mol%.

In the case the content [B2] is lower than the range described above, it may become impossible to sufficiently achieve the effect of the present invention, which is forming the molten zone by heating and melting initial melt region.

That is, it may become impossible to sufficiently achieve the effect of suppressing boron from falling into deficiency in the boride single crystal that is grown in the portion that the molten zone has passed thereby to improve the crystallinity of the boride single crystal, by setting the temperature of the molten zone lower than in the case of prior art so as to suppress the boron from evaporating from the molten zone, and forming the initial melt region essentially to include an excessive content of boron.

In the case the content [B2] is higher than the range described above, the boron content becomes excessive and is likely to separate in the boride single crystal that is grown in the portion that the molten zone has passed. As a result, the crystallinity of the boride single crystal that is manufactured may become lower contrary to the intention. In the case the content [B2] of boron is in the range described above, in contrast, the crystallinity of the boride single crystal that is manufactured can be improved further.

It is preferable that the boride single crystal manufactured by the method of the present invention containing the boride represented by the formula (1) contains boron and a metallic element that constitute the boride represented by the formula (1) having a content of boron [B3] to the total amount of the boron and the metallic element set to [B3] = 66.4 to 67 mol%.

The content [B3] less than the range described above leads to a larger amount of the metallic element that is separated, and the content [B3] higher than the range described above leads to a larger amount of boron that is separated. In either of these cases, the boride single crystal may have a lower crystallinity with much macroscopic defects such as void defect, dislocation and crystal grain boundary. When the content [B3] of boron is within the range described above, in contrast, the resulting boride single crystal is excellent in crystallinity with suppressed macroscopic defects such as void defect, dislocation and crystal grain boundary.

In order to manufacture the boride single crystal having an excellent crystallinity with the suppressed macroscopic defects as described above, it is preferable to control the content [B1] of boron in the ingredient powder used to form the feed rod, the content [B2] of boron in the ingredient powder used to form the initial melt region and the content [B3] of boron in the boride single crystal manufactured, so as to satisfy the relation (2):

$$[B2] \geq [B1] \geq [B3] \qquad (2)$$

which satisfies the relation (3) above all:

$$[B2] \geq [B1] > [B3] \qquad (3)$$

which satisfies the relation (4) particularly:

$$[B2] > [B1] > [B3] \qquad (4)$$

The feed rod and the initial melt region used in the manufacturing method of the invention may be formed and sintered integrally in a single piece from the respective ingredient powders, or may be formed separately and used in the manufacture of the boride single crystal by putting the initial melt region into contact with one end of the feed rod.

The present invention is a substrate for growing a semiconductor layer on a surface thereof, which is formed from the boride single crystal manufactured by the manufacturing method of the present invention.

The substrate of the present invention is made by cutting the boride single crystal along a predetermined crystal orientation, having an excellent crystallinity, which is manufactured by the manufacturing method of the present invention so that the macroscopic defects such as void defect, dislocation and crystal grain boundary are suppressed from occurring. Therefore, it is possible to grow a satisfactory semiconductor layer such as a GaN-based semiconductor layer having a low dislocation density on the surface thereof.

BRIEF DESCRIPTION OF THE DRAWINGS

Fig. 1 is a sectional view showing an internal structure of an example of a single crystal growing apparatus used for implementing the method for manufacturing the boride single crystal according to the present invention.

Fig. 2 is a sectional view showing a stage in a process of manufacturing the boride single crystal of the present invention by using the single crystal growing apparatus shown in Fig. 1.

Fig. 3 is a graph showing a relation between the boron content [B2] in an ingredient powder used in forming an initial melt region in Example 1 of the present invention and full width at half maximum (seconds) of X-ray reflectivity curve observed by an X-ray reflectivity method on a principal surface along the (0002) plane of crystal formed by cutting and polishing $ZrB_2$ single crystal that is made by using the initial melt region.

Fig. 4 is a graph showing a relation between the boron content [B3] in the $ZrB_2$ single crystal made in Example 1 of the present invention and a proportion of area (%) occupied by macroscopic defects in unit area of the principal surface.

DETAILED DESCRIPTION OF THE PREFERRED EMBODIMENT

The present invention is characterized in that, when manufacturing a boride single crystal by a floating zone method, an initial melt region formed from an ingredient powder including a higher content of boron than a stoichiometric composition of the boride is provided at one end of a feed rod formed from an ingredient powder containing boron and a metallic element that constitute the boride in the longitudinal direction thereof, heating and melting the initial melt region so as to form a molten zone, and the molten zone is moved from the initial melt region toward the other end of the feed rod along the longitudinal direction, so as to grow the boride single crystal in a portion of the feed rod that the molten zone has passed.

The feed rod may be prepared by forming an ingredient powder containing a boride or boron and a metallic element that makes a boride single crystal into a rod shape by a compression molding or the like, and sintering the rod by heating to a temperature below the melting point of boron (approximately 2300°C).

As is previously described, it is preferable to use the feed rod formed from the ingredient powder that includes a content of boron in excess of the stoichiometric composition of the boride. In the case the boride represented by the formula (1), such as $ZrB_2$ that is suitable for an epitaxial growth of a GaN-based semiconductor layer is used, it is preferable to form the feed rod from an ingredient powder that contains boron in a content of [B1] to the total amount of the boron and the metallic element set to [B1] = 67 to 72 mol%:

$$MB_2 \quad (1)$$

where M represents at least one metallic element selected from the group consisting of Zr, Ti, Cr, Hf and Ta.

The initial melt region may be prepared by forming an ingredient powder including a content of boron in excess of the stoichiometric composition of the boride by a compression molding or the like, and sintering it by heating to a temperature below the melting point of boron. In the case the boride is represented by the formula (1), it is preferable to form the initial melt region from an ingredient powder that contains boron in a content $[B2]$ to the total amount of the boron and the metallic element being set to $[B2] = 72$ to 90 mol%.

In the case the boride is represented by the formula (1), the boride single crystal manufactured by the method of the present invention is preferably to have a content of boron $[B3]$ to the total amount of the boron and the metallic element being set to $[B3] = 66.4$ to 67 mol%. The values of contents $[B1]$ through $[B3]$ are preferably controlled so as to satisfy the relation (2):

$$[B2] \geq [B1] \geq [B3] \quad (2)$$

which satisfies the relation (3) above all:

$$[B2] \geq [B1] > [B3] \quad (3)$$

which satisfies the relation (4) particularly:

$$[B2] > [B1] > [B3] \quad (4)$$

These reasons are as thus far described in the above. The boron content in the ingredient powder used to make the feed rod and the initial melt region may be controlled within the range described above by, for example, adding boron to a boride that has a predetermined stoichiometric composition, or mixing boron and a metallic element in such a proportion that satisfies the range described above.

The boron content in the boride single crystal that is manufactured may be controlled within the range described above by controlling the boron content in the ingredient powder used to form the feed rod or the initial melt region within the range described above, or controlling an atmospheric gas pressure, temperature of the molten zone, moving speed or the like during the process of the floating zone method.

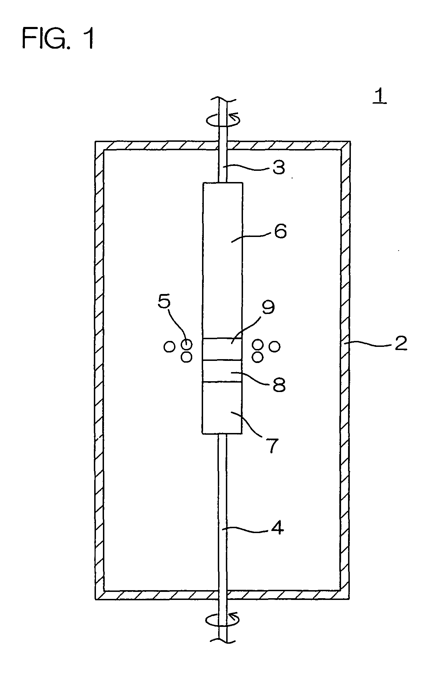

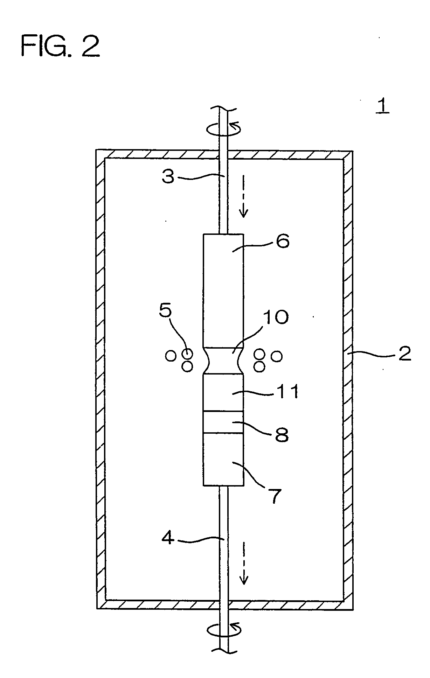

The method for manufacturing a boride single crystal according to the present invention may be carried out similarly to the prior art, except that the initial melt region is provided and the boron content is controlled. Fig. 1 is a sectional view showing an internal structure of an example of a single crystal growing apparatus used for implementing the method for manufacturing the boride single crystal according to the present invention. Fig. 2 is a sectional view showing a stage in a process of manufacturing the boride single crystal of the present invention by using the single crystal growing apparatus shown in Fig. 1.

Refer to Fig. 1, the single crystal growing apparatus 1 of this example comprises:

a pressure vessel 2;
a drive shaft 3 penetrating through the pressure vessel 2 from above into the inside thereof with an axis disposed in the vertical direction (direction from the top to the bottom in Fig. 1) and the bottom end thereof protruding in the pressure vessel 2;
a drive shaft 4 penetrating through the pressure vessel 2 from below into the inside thereof with an axis disposed in the vertical direction in alignment with the axis of the drive shaft 3 and the top end thereof protruding in the pressure vessel 2; and
an induction coil 5 formed nearly in a ring shape and disposed in the pressure vessel 2 in a concentric arrangement with the drive shafts 3, 4.

Among the members described above, the drive shafts 3, 4 are disposed so as to be vertically movable along the axial direction while rotating around the axis individually, as indicated by arrows of solid line in the drawing, driven by a drive mechanism, not shown, which is disposed outside of the pressure vessel 2, while maintaining the pressure vessel 2 airtight. While the drive shafts 3, 4 are illustrated as disposed to rotate in the same direction indicated by the arrows around the axis thereof, the drive shafts 3, 4 may also rotate in directions opposite to each other.

When the single crystal growing apparatus 1 shown in Fig. 1 is used, the manufacturing method of the present invention is carried out as follows: First, a feed rod 6 formed in a rod shape from an ingredient powder that contains boride is held onto the bottom end of the drive shaft 3 so as to extend downward in alignment with the axial direction and the axis of the drive shaft 3. A seed crystal 8 that serves as crystal growth point is held via a spacer 7 on the top end of the drive shaft 4.

Since the seed crystal 8 may have a minimum necessary thickness, Fig.1 shows the seed crystal 8 is held via a spacer 7 on the top end of the drive shaft 4 in order to make it easier to mount the seed crystal 8 on the drive shaft 4 and prevent the drive shaft 4 from being directly affected by the heat of induction heating. However the seed crystal 8 may also be mounted directly on the top end of the drive shaft 4 without interposing the spacer 7.

While the spacer 7 may be formed from any heat resistant material that endures the melting temperature of the boride, the spacer is preferably made of a sintered boride in order to prevent the composition of the boride single crystal from being affected by the spacer.

The feed rod 6 has, on one end (bottom end in Fig.1) in the longitudinal direction thereof, the initial melt region 9 formed from an ingredient powder including a content of boron in excess of the stoichiometric composition of the boride. The initial melt region 9 may be either formed as an integral part of the feed rod 6, or interposed between the bottom end of the feed rod 6 and the seed crystal 8 by adjusting the vertical positions of the drive shafts 3, 4 so as to make contact with the bottom end of the feed rod 6.

Then the pressure vessel 2 is closed, with the air purged from the inside, and is filled with an inert gas of several atms. Under this condition, vertical positions of the drive shafts 3, 4 are adjusted so that height of the initial melt region 9 becomes equal to that of the induction coil 5 and the initial melt region 9 is surrounded by the induction coil 5, as shown in Fig. 1.

Then an alternating voltage is applied to the induction coil 5 from an oscillator while rotating the drive shafts 3, 4 in the same direction indicated by the arrows of solid line in the drawing so as to heat the initial melt region 9 to a temperature not lower than the melting point of the ingredient powder by the Joule heat generated in the initial melt region 9 to melt by induction heating. The alternating voltage applied to the induction coil 5 has a frequency preferably in a range from about 150 kHz to 2.4 MHz.

Refer to Fig. 2, as the drive shafts 3, 4 are moved downward as indicated by a dot-and-dash line in the drawing while rotating respectively, the molten zone 10 having a predetermined length along the length of the feed rod 6 formed by melting the initial melt region 9 moves relatively toward the other end (top end in Fig.2) of the feed rod 6. At the same time, a boride single crystal 11 grows below the molten zone 10 with the lattice matched with that of the seed crystal 8 by cool down and solidification of the melt after the molten zone 10 has passed. A rotation of the drive shafts 3, 4 is preferably not faster than about 30 rpm and a moving velosity of the drive shafts 3, 4 downward is preferably in a range approximately from 1 to 20 mm per hour, which is the rate of crystal growth.

As is described previously, the manufacturing method of the present invention makes it possible to manufacture the boride single crystal 11 while keeping the temperature of the molten zone 10 lower than that of the molten zone formed by melting the boride having a same composition as the stoichiometric composition in the prior art. In the case of $ZrB_2$, for example, a single crystal can be manufactured by setting the melting temperature of the molten zone 10 in a range from 2600 to 2900°C, which is lower than the melting temperature of about 3000°C that of the $ZrB_2$.

As a result, by suppressing the boron deficiency, the boride single crystal 11 having an excellent crystallinity can be manufactured with the reduced defects such as boron defect and separation of the metallic element due to the boron deficiency, thereby suppressing the occurrence of macroscopic defects such as void defect, dislocation and crystal grain boundary. In the case the boride is represented by the formula (1) described above, for example, an excellent crystallinity can be achieved by controlling a content of the boron [B3] to the total amount of the boron and the metallic element in a range of [B3] = 66.4 to 67 mol%.

The substrate according to the present invention is characterized in that it is made from the boride single crystal manufactured by the method of the present invention. Specifically, the substrate of the present invention is formed by, for example, cutting the boride single crystal along a predetermined crystal orientation. When the substrate of the present invention made of $ZrB_2$ is used, for example, it is possible to grow a satisfactory GaN-based semiconductor layer having a low dislocation density that has been impossible to form in the prior art.

Examples

Example 1

Seven kinds of ingredient powder used to form a feed rod including a boron content [B1] of 64 mol %, 65 mol %, 67 mol %, 70 mol %, 72 mol %, 75 mol % and 76 mol % were made by adding a boron powder to $ZrB_2$ powder having a mean particle size of 1 $\mu$m. The ingredient powders were formed into round rod shape measuring 19 mm in diameter and 150 mm in length by a press molding under a pressure of about 98 MPa. The rods were then heated to about 1900°C so as to sinter in a vacuum furnace, thereby making the seven kinds of feed rod.

Also, five kinds of ingredient powder used to form an initial melt region including a boron content [B2] of 65 mol %, 72 mol %, 80 mol %, 90 mol %, and 95 mol % were made by adding a boron powder to $ZrB_2$ powder having a mean particle size of 1 $\mu$m. Eight gram each of the ingredient powders was formed into a round rod shape measuring 19 mm in diameter and 14 mm in length by a press molding under a pressure of about 98 MPa. The rods were then heated to about 1900°C so as to sinter in a vacuum furnace, thereby making the five kinds of initial melt region.

Refer to Fig. 1, seven kinds of feed rod 6 and five kinds of initial melt region 9 were combined as shown in Table 1, and were set together with $ZrB_2$ single crystal measuring 15 mm in diameter as a seed crystal 8 and sintered $ZrB_2$ as a spacer 7 at a position between drive shafts 3, 4 within a pressure vessel 2 of a single crystal growing apparatus 1 shown in Fig.1. Then after closing the pressure vessel 2 and evacuating the air from the inside of the pressure vessel 2 until the pressure therein decreased to 10 Pa or lower, argon gas was supplied so as to provide an inert gas atmosphere of 0.5 MPa in the pressure vessel 2.

As shown in Fig. 1, vertical positions of the drive shafts 3, 4 were adjusted so that height of the initial melt region 9 became equal to that of an induction coil 5 and the initial melt region 9 was arranged to be surrounded by the induction coil 5. An alternating voltage was applied to the induction coil 5 while rotating the drive shafts 3, 4 at a speed of 2 rpm in the same direction indicated by arrows of solid line in the drawing so as to heat and melt the initial melt region 9 by Joule heat generated in the initial melt region 9 by induction heating to form a molten zone 10. The alternating voltage applied to the induction coil 5 had a frequency of 430 kHz with power of 35 kW.

Then the drive shafts 3, 4 were moved vertically downward at a speed of 5.0 mm per hour as indicated by a dot-and-dash line in Fig. 2 while rotating, and the molten zone 10 was moved vertically upward along the feed rod 6. The operation was continued until a $ZrB_2$ single crystal grew with a lattice matched with that of the seed crystal 8 to a length of about 50 mm as the portion that cool down and solidification of a melt after the molten zone 10 has passed.

In the manufacturing process, as shown in Table 1, with the feed rod formed from the ingredient powders including the boron content [B1] of less than 67 mol%, the molten zone 10 was solidified halfway and with those of [B1] exceeding 72 mol% the molten zone 10 drooped, resulting in a failure to continue to grow the crystal in each case, while the crystal could be grow stably so as to reach the predetermined length when the feed rods having the content [B1] in a range from 67 to 72 mol% were used. From these results, it was verified that the boron content [B1] in the ingredient powder used to form the feed rod used in the manufacture of the $ZrB_2$ single crystal by the manufacturing method of the present invention is preferably in a range from 67 to 72 mol%.

Table 1

| | | [B1] (Mol%) | | | | | | |
|---|---|---|---|---|---|---|---|---|
| | | 64 | 65 | 67 | 70 | 72 | 75 | 76 |
| [B2] (Mol%) | 65 | Solidified | Solidified | Good | Good | Good | Drooped | Drooped |
| | 72 | Solidified | Solidified | Good | Good | Good | Drooped | Drooped |
| | 80 | Solidified | Solidified | Good | Good | Good | Drooped | Drooped |
| | 90 | Solidified | Solidified | Good | Good | Good | Drooped | Drooped |
| | 95 | Solidified | Solidified | Good | Good | Good | Drooped | Drooped |

The alternating voltage applied to the induction coil 5 was gradually decreased to zero, after necking the molten zone 10 when the $ZrB_2$ single crystal grew to about 50 mm in length for the samples with good result in Table 1, or when the molten zone solidified or drooped for the other samples. After natural cooling down the grown $ZrB_2$ single crystal to room temperature (5 to 35°C), the $ZrB_2$ single crystal was taken out of the pressure vessel 2.

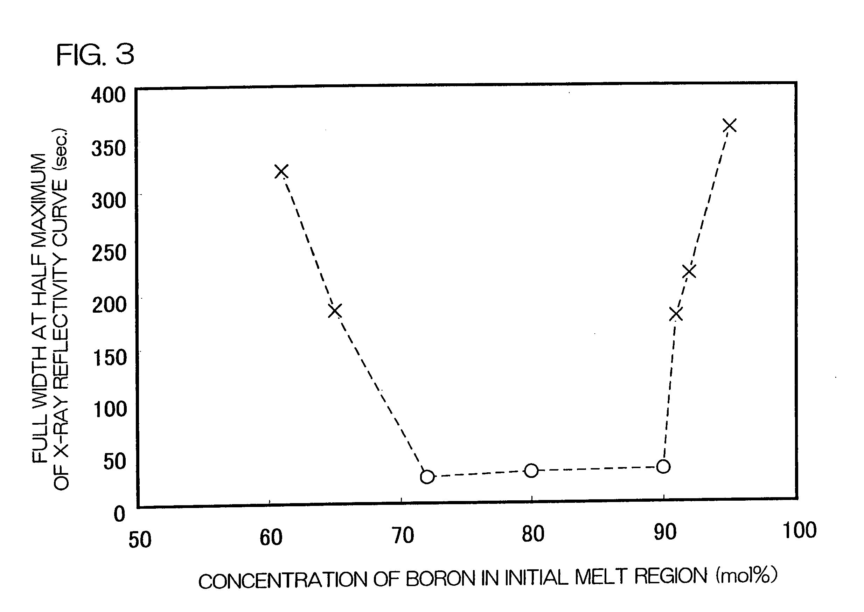

The $ZrB_2$ single crystal was then cut along the (0002) plane as the principal surface and was polished. A full width at half maximum of X-ray reflectivity curve was observed by X-ray reflectivity method on the principal surface of the crystal by means of an X-ray diffraction apparatus (X'Pert PRO MPD manufactured by PANalytical Division of Spectris Co., Ltd.) from an X-ray reflectivity curve (diffraction intensity distribution) obtained by scanning an X-ray incident angle and a diffraction angle θ under conditions of the diffraction plane (10-11) and a diffraction angle 2θ = 41.63°. A relation between the full width at half maximum and the boron content [B2] in the ingredient powder used to form the initial melt region is shown in Fig. 3.

From Fig. 3, it was verified that, in the case a boron content [B2] in the ingredient powder used to form the initial melt region is less than 72 mol% or higher than 90 mol%, the full width at half maximum is far larger than 100 seconds that corresponds to a dislocation density of about $10^{-6}$ cm$^{-2}$ thus indicating a unsatisfactory crystallinity, while a $ZrB_2$ single crystal of a good crystallinity can be manufactured with a full width at half maximum less than 100 seconds when the boron content [B2] is in a range from 72 to 90 mol%.

It was also found from a chemical analysis that, when the content [B2] is less than 72 mol%, the single crystal tends to become deficient in boron, and also found from an observation of the principal surface, that zirconium separates.

Also it was found from an observation of the principal surface that, when the content [B2] is higher than 90 mol%, boron separates, and found that, from the result of X-ray analysis, an excessively high value of the [B2] results in a mixed crystal of $ZrB_2$ and $ZrB_{12}$ thus making it impossible to obtain $ZrB_2$ single crystal.

From these results, it was verified that it is preferable to control the boron content [B2] in a range from 72 to 90 mol% in the ingredient powder used to form the initial melt region when manufacturing a $ZrB_2$ single crystal by the method according to the present invention.

The measurement of temperature of the molten zone while growing the $ZrB_2$ single crystal by means of an infrared thermometer showed that the temperature of the molten zone can be maintained in a range from 2600 to 2900°C, which is lower than the melting temperature of about 3000°C that of the $ZrB_2$ in the case the feed rod having a boron content [B1] in a range from 67 to 72 mol% and the initial melt region having a boron content [B2] in a range from 72 to 90 mol% are used in combination.

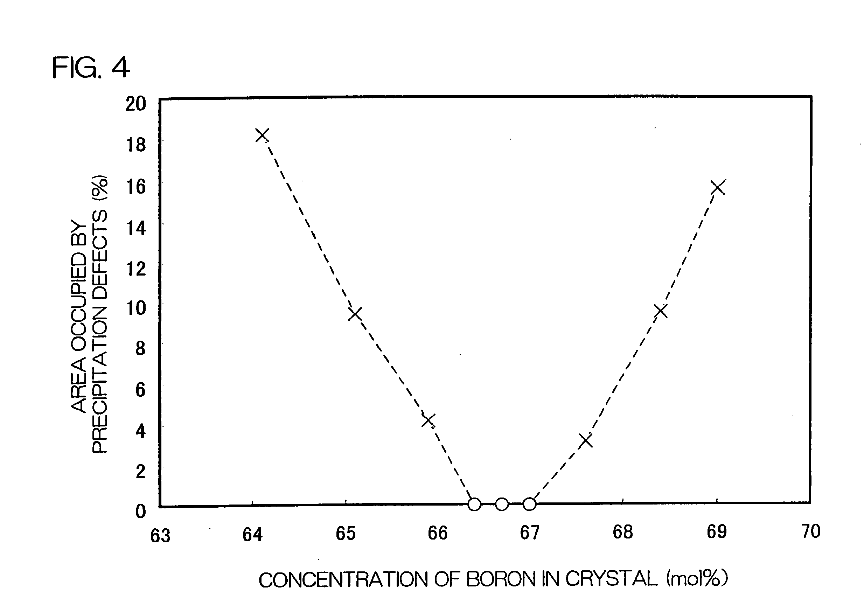

Fig. 4 is a graph showing a relation between the boron content [B3] in the $ZrB_2$ single crystal that is manufactured, measured by a chemical analysis, and the proportion of area (%) occupied by macroscopic defects caused by a separation of zirconium or boron in a unit area of the principal surface along the (0002) plane formed by cutting and polishing the $ZrB_2$ single crystal.

From Fig. 4, it has been verified that zirconium separates when the boron content [B3] in the $ZrB_2$ single crystal that is manufactured is less than 66.4 mol% and boron separates when the boron content [B3] is higher than 67 mol%, while defects of neither type occur when [B3] is in a range from 66.4 to 67 mol%.

The full width at half maximum described above was measured on the (0002) plane and the (10-10) plane. It was found that samples having the [B3] out of the range from 66.4 to 67 mol% show a large full width at half maximum of 200 to 600 seconds, while samples having the [B3] in the range described above show a small full width at half maximum of 30 seconds on the (0002) plane and 35 seconds on the (10-10) plane, thus producing a $ZrB_2$ single crystal having a good crystallinity. These results show that a boron content [B3] in the $ZrB_2$ single crystal manufactured by the method of the present invention is preferably in a range from 66.4 to 67 mol%.

Example 2

An ingredient powder including a boron content [B1] of 70 mol % was formed into a round rod shape measuring 19 mm in diameter and 150 mm in length by a press molding under a pressure of about 98 MPa, thereby preparing a precursor of feed rod.

An ingredient powder including a boron content [B2] of 80 mol % was formed into a round rod shape measuring 19 mm in diameter and 15 mm in length by a press molding under a pressure of about 98 MPa, thereby preparing a precursor of initial melt region.

The precursor of initial melt region put into contact with one end of the precursor of feed rod were then heated to about 1900°C in a vacuum furnace, thereby making an assembly of the feed rod 6 and the initial melt region 9 provided at one end of the feed rod 6 formed in an integral body as shown in Fig. 1.

The assembly of the feed rod 6 and the initial melt region 9 formed in an integral body was set between the drive shafts 3 and 4 in the pressure vessel 2 of the single crystal growing apparatus 1 shown in Fig. 1, together with the seed crystal 8 made of a $ZrB_2$ single crystal measuring 15 mm in diameter and the spacer 7 made of sintered $ZrB_2$, which were the same as those used in Example 1.

A $ZrB_2$ single crystal was grown by carrying out the same operation under the same condition as those in Example 1. At the same time as the growth of the crystal started, the composition of the molten zone shifted to an excessive boron content. The concentration of boron in the $ZrB_2$ single crystal thus manufactured was 66.7 to 67.0 mol% in a region from the start point of growth to a point of 40 mm in the longitudinal direction, indicated that the state of the boron content not less than the stoichiometric composition of $ZrB_2$ was maintained from the start to the end of the growth of the $ZrB_2$ single crystal.

A full width at half maximum was measured at a plurality of positions along the longitudinal direction exposed by slicing the ZrB2 single crystal thus manufactured. The full width at half maximum was in a range from 30 to 100 seconds, indicating that a good crystallinity was maintained.

Meanwhile, a $ZrB_2$ single crystal was manufactured by a similar operation as described above using only the feed rod without the initial melt region as in the prior art, and a full width at half maximum was measured at a plurality of positions along the longitudinal direction exposed by slicing the $ZrB_2$ single crystal thus manufactured. A large full width at half maximum of this $ZrB_2$ single crystal was observed in a range from 200 to 800 seconds, indicating a poor crystallinity. Observation of the sliced surfaces showed a separation of zirconium and void defects due to the separate coming off to an extent of about $5 \times 10^6$ cm$^{-2}$ in terms of density per unit area.

While only the $ZrB_2$ single crystal was examined in Examples 1 and 2, similar results were obtained in the case of other borides, where Zr is partially or entirely substituted with at least one kind of metallic element selected from the group consisting of Ti, Cr, Hf and Ta.

**Claims**

1. A method for manufacturing a boride single crystal (11) by a floating zone method from a feed rod (6) that is formed from an ingredient powder containing boron and a metallic element that constitute a boride, comprising the steps of:

   providing an initial melt region (9) formed from an ingredient powder including a content of boron in excess of the stoichiometric composition of the boride at one end of the feed rod (6) in the longitudinal direction thereof and heating the initial melt region (9) so as to melt and form a molten zone (10) of a predetermined length in the longitudinal direction; and
   moving the molten zone (10) from the initial melt region (9) toward the other end of the feed rod (6) along the longitudinal direction, so as to grow the boride single crystal (11) in a portion of the feed rod (6) that the molten zone (10) has passed.

2. The method for manufacturing a boride single crystal (11) according to claim 1, wherein the feed rod (6) is formed from an ingredient powder that includes a content of boron in excess of the stoichiometric composition of the boride.

3. The method for manufacturing a boride single crystal (11) according to claim 1, wherein the boride is represented by the formula (1):

$$MB_2 \quad (1)$$

   wherein M represents at least one metallic element selected from the group consisting of Zr, Ti, Cr, Hf and Ta.

4. The method for manufacturing a boride single crystal (11) according to claim 3, wherein the feed rod (6) is formed from an ingredient powder containing boron and a metallic element that constitute the boride represented by the formula (1) and the ingredient powder having a content of boron [B1] to the total amount of the boron and the metallic element set to
   [B1] = 67 to 72 mol%.

5. The method for manufacturing a boride single crystal (11) according to claim 3, wherein the initial melt region (9) is formed from an ingredient powder containing boron and a metallic element that constitute the boride represented by the formula (1) and having a content of boron [B2] to the total amount of the boron and the metallic element set to
   [B2] = 72 to 90 mol%.

6. The method for manufacturing a boride single crystal (11) according to claim 3, wherein a content of boron [B3] to the total amount of the boron and the metallic element that constitute the boride represented by the formula (1) in the boride single crystal (11) that is manufactured is set to
   [B3] = 66.4 to 67 mol%.

7. The method for manufacturing a boride single crystal (11) according to claim 3, wherein the content [B1] of boron in the ingredient powder used to form the feed rod (6), the content [B2] of boron in the ingredient powder used to form the initial melt region (9) and the content [B3] of boron in the boride single crystal (11) that is manufactured are controlled so as to satisfy the relation (2):

$$[B2] \geq [B1] \geq [B3] \qquad (2)$$

8. The method for manufacturing a boride single crystal (11) according to claim 3, wherein the boride is $ZrB_2$.

9. The method for manufacturing a boride single crystal (11) according to claim 1, wherein the feed rod (6) and the initial melt region (9) are formed integrally.

10. The method for manufacturing a boride single crystal (11) according to claim 1, wherein the feed rod (6) and the initial melt region (9) are formed separately and are used with the initial melt region (9) being brought into contact with one end of the feed rod (6).

11. A substrate for growing a semiconductor layer on a surface thereof, which is formed from the boride single crystal (11) manufactured according to the method for manufacturing a boride single crystal (11) of claim 1.

FIG. 1

FIG. 2

FIG. 3

FULL WIDTH AT HALF MAXIMUM OF X-RAY REFLECTIVITY CURVE (sec.)

CONCENTRATION OF BORON IN INITIAL MELT REGION (mol%)

FIG. 4

**European Patent Office**

**EUROPEAN SEARCH REPORT**

Application Number

EP 06 01 5542

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | OTANI S ET AL: "Preparation of ZrB2 single crystals by the floating zone method" JOURNAL OF CRYSTAL GROWTH, ELSEVIER, AMSTERDAM, NL, vol. 165, no. 3, August 1996 (1996-08), pages 319-322, XP004008106 ISSN: 0022-0248 * table 1 * | 1-6,8,9, 11 | INV. C30B29/10 C30B13/00 |
| X,D | JP 10 095699 A (NAT INST RES INORGANIC MAT) 14 April 1998 (1998-04-14) * abstract * | 1-6,8,9, 11 | |
| X,D | JP 2002 043223 A (NAT INST FOR MATERIALS SCIENCE; KYOCERA CORP; OTANI SHIGEKI; SUDA ATSU) 8 February 2002 (2002-02-08) * abstract * | 11 | |
| X | & EP 1 176 231 A2 (NAT INST FOR MATERIALS SCIENCE [JP]; KYOCERA CORP [JP]) 30 January 2002 (2002-01-30) * claim 1 * | 11 | TECHNICAL FIELDS SEARCHED (IPC) |
| X | OTANI S ET AL: "Floating zone growth and high-temperature hardness of CrB2 single crystals" JOURNAL OF CRYSTAL GROWTH, ELSEVIER, AMSTERDAM, NL, vol. 200, no. 3-4, April 1999 (1999-04), pages 472-475, XP004168209 ISSN: 0022-0248 * table 1 * | 1-6,9,11 | C30B |

-/--

The present search report has been drawn up for all claims

| Place of search | Date of completion of the search | Examiner |
|---|---|---|
| The Hague | 10 November 2006 | Cook, Steven |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

## EUROPEAN SEARCH REPORT

Application Number

EP 06 01 5542

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | OTANI ET AL.: "Floating Zone Growth of TiB2 single crystals using SHS Rods" INT. J. SELF-PROPAGATING HIGH TEMPERATURE SYNTHESIS, vol. 3, no. 1, 1994, pages 93-97, XP002406781 * table 1 * | 1-6,9,11 | |
| X | EP 1 538 243 A (NAT INST FOR MATERIALS SCIENCE [JP]; KYOCERA CORP [JP]) 8 June 2005 (2005-06-08) | 11 | |
| A | * paragraph [0048]; claim 1 * | 1-10 | |
| X | OTANI S ET AL: "Preparation of HfB2 and ZrB2 single crystals by the floating-zone method" JOURNAL OF CRYSTAL GROWTH, ELSEVIER, AMSTERDAM, NL, vol. 186, no. 4, 7 March 1998 (1998-03-07), pages 582-586, XP002406887 ISSN: 0022-0248 * page 585; table 1 * | 1-6,8,9,11 | |
| A,D | JP 2002 348200 A (NAT INST FOR MATERIALS SCIENCE; KYOCERA CORP) 4 December 2002 (2002-12-04) | | TECHNICAL FIELDS SEARCHED (IPC) |

The present search report has been drawn up for all claims

| Place of search | Date of completion of the search | Examiner |
|---|---|---|
| The Hague | 10 November 2006 | Cook, Steven |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 01 5542

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2006

| Patent document cited in search report | | Publication date | Patent family member(s) | | Publication date |
|---|---|---|---|---|---|
| JP 10095699 | A | 14-04-1998 | NONE | | |
| JP 2002043223 | A | 08-02-2002 | EP<br>US | 1176231 A2<br>2002038892 A1 | 30-01-2002<br>04-04-2002 |
| EP 1176231 | A2 | 30-01-2002 | JP<br>US | 2002043223 A<br>2002038892 A1 | 08-02-2002<br>04-04-2002 |
| EP 1538243 | A | 08-06-2005 | CN<br>WO<br>JP<br>US | 1678772 A<br>2004018743 A1<br>2004083319 A<br>2006102924 A1 | 05-10-2005<br>04-03-2004<br>18-03-2004<br>18-05-2006 |
| JP 2002348200 | A | 04-12-2002 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002043223 A
- JP 2002348200 A
- JP H10095699 A

### Non-patent literature cited in the description

- **HIROSHI AMANO et al.** *Relationship between Dislocation Density and Emission Efficiency in AlGaN-based Light Emitting Diodes,* 2002, vol. 29 (3), 12-17
- **ISAMU AKASAKI.** Semiconductor based on Nitride of Group III Element. BAIFUKAN CO., LTD, 08 December 1999, 122-124
- **HIDETO MIYAKE.** Technology to Achieve Higher Luminance, Higher Efficiency and Longer Service Life of White LED Illumination System. Technical Information Institute Co., Ltd, 27 March 2003, 65-72